# EUROPEAN PATENT APPLICATION

(11) **EP 4 772 897 A1**
(43) Date of publication of application: **08.07.2026**
(21) Application number: 23958131.7
(22) Date of filing: 07.12.2023
(51) Int. Cl.: G01R 31/378

(54) **BATTERY CELL LITHIUM PRECIPITATION POTENTIAL DETERMINATION METHOD AND APPARATUS, STORAGE MEDIUM AND ELECTRONIC DEVICE**

(30) Priority: 06.11.2023 CN 202311471786
(71) Applicant: Eve Energy Co., Ltd., Huizhou, Guangdong 516006 (CN)
(72) Inventor: ZHENG, Yuanyuan, Huizhou, Guangdong 516006 (CN); LI, Wei, Huizhou, Guangdong 516006 (CN)
(74) Representative: Murgitroyd & Company
(86) International application number: PCT/CN2023/137257
(87) International publication number: WO 2025/097532

(57) **Abstract**

The present application relates to method and apparatus for determining a lithium plating potential of a battery cell, storage medium, and electronic device, wherein the method includes: obtaining a voltage and a capacity of the battery cell at different charging rates, and a voltage and a capacity of the battery cell at the same discharge rate; plotting a first relationship curve and a second relationship curve; plotting a charging capacity differential curve based on the first relationship curve, and plotting a discharge capacity differential curve based on the second relationship curve; and finally determining the lithium plating potential of the battery cell based on the two differential curves.

## Description

This application claims priority to the Chinese patent application filed on 6 November 2023 with application number 202311471786.0, the entire content of which is incorporated herein by reference.

### TECHNICAL FIELD

The present application relates to the field of battery technology, for example to a method for determining a lithium plating potential of a battery cell, an apparatus, a computer-readable storage medium, and an electronic device.

### BACKGROUND

In the related art, commonly used test methods for the lithium plating potential of a lithium-ion battery include: a voltage relaxation method, a direct-current internal resistance method, a three-electrode method, and the like. Among these, the voltage relaxation method and the direct-current internal resistance method have low test accuracy for the lithium plating potential of a lithium battery, require a large number of test samples, and have a long test cycle. The three-electrode method for testing the lithium plating potential of a lithium battery requires implanting a reference electrode, necessitates the preparation of special samples, and has a long preparation cycle and a complex process. The current methods for determining the lithium plating potential all suffer from problems of inaccuracy or low efficiency.

### SUMMARY

The present application provides a method for determining a lithium plating potential of a battery cell, an apparatus, a computer-readable storage medium, and an electronic device, which are capable of improving the accuracy and efficiency of determining the lithium plating potential of a battery cell.

To achieve the above object, the present application adopts the following technical solutions:
In a first aspect, an embodiment of the present application provides a method for determining a lithium plating potential of a battery cell, comprising:
obtaining a charging voltage and a charging capacity of a battery cell at different charging rates, and a discharge voltage and a discharge capacity of the battery cell at a same discharge rate;
plotting a first relationship curve of the charging voltage and the charging capacity at different charging rates, and plotting a second relationship curve of the discharge voltage and the discharge capacity at a same discharge rate;
plotting a charging capacity differential curve based on the first relationship curve, and plotting a discharge capacity differential curve based on the second relationship curve;
determining the lithium plating potential of the battery cell based on the charging capacity differential curve and the discharge capacity differential curve.

In a second aspect, an embodiment of the present application provides an apparatus for determining a lithium plating potential of a battery cell, the apparatus comprising:
an acquisition module, configured to obtain a charging voltage and a charging capacity of a battery cell at different charging rates, and a discharge voltage and a discharge capacity of the battery cell at a same discharge rate;
a first plotting module, configured to plot a first relationship curve of the charging voltage and the charging capacity at different charging rates, and to plot a second relationship curve of the discharge voltage and the discharge capacity at a same discharge rate;
a second plotting module, configured to plot a charging capacity differential curve based on the first relationship curve, and to plot a discharge capacity differential curve based on the second relationship curve;
a determination module, configured to determine the lithium plating potential of the battery cell based on the charging capacity differential curve and the discharge capacity differential curve.

In a third aspect, an embodiment of the present application provides a computer-readable storage medium, wherein a plurality of instructions are stored in the computer-readable storage medium, the instructions being adapted to be loaded by a processor to execute the steps of the above method for determining a lithium plating potential of a battery cell.

In a fourth aspect, an embodiment of the present application provides an electronic device, the electronic device comprising: one or more processors; a memory; and one or more instructions, wherein the one or more instructions are stored in the memory and configured to be executed by the processors to carry out the steps of the above method for determining a lithium plating potential of a battery cell.

### ADVANTAGEOUS EFFECTS

The advantageous effects of the present application are as follows: the method for determining a lithium plating potential of a battery cell, the apparatus, the computer-readable storage medium, and the electronic device provided by the present application obtain a charging voltage and a charging capacity of a battery cell at different charging rates, and a discharge voltage and a discharge capacity of the battery cell at a same discharge rate, plot a first relationship curve of the charging voltage and the charging capacity at different charging rates, and plot a second relationship curve of the discharge voltage and the discharge capacity at a same discharge rate, plot a charging capacity differential curve based on the first relationship curve, and plot a discharge capacity differential curve based on the second relationship curve, and determine the lithium plating potential of the battery cell based on the charging capacity differential curve and the discharge capacity differential curve. The embodiments of the present application determine the lithium plating potential of the battery cell by combining the charging capacity differential curve and the discharge capacity differential curve, ensuring that the determination of the lithium plating potential takes into account both the charging condition and the discharge condition of the battery cell, thereby making the determined lithium plating potential more accurate, shortening the time required for determining the lithium plating potential, and improving the efficiency of determining the lithium plating potential.

### BRIEF DESCRIPTION OF THE DRAWINGS

FIG. 1 is a schematic flowchart of a method for determining a lithium plating potential of a battery cell provided by an embodiment of the present application;
FIG. 2 is a schematic diagram of a first relationship curve of voltage and capacity at different charging rates provided by an embodiment of the present application;
FIG. 3 is a schematic diagram of a second relationship curve of voltage and capacity at a same discharge rate provided by an embodiment of the present application;
FIG. 4 is a schematic diagram of discharge capacity differential curves at different charging rates and a same discharge rate provided by an embodiment of the present application;
FIG. 5 is a schematic diagram of discharge capacity differential curves at different charging rates and a same discharge rate provided by an embodiment of the present application;
FIG. 6 is a schematic diagram of charging capacity differential curves at different charging rates provided by an embodiment of the present application;
FIG. 7 is a schematic diagram of an apparatus for determining a lithium plating potential of a battery cell provided by an embodiment of the present application;
FIG. 8 is a schematic structural diagram of an electronic device provided by an embodiment of the present application.

### DETAILED DESCRIPTION OF EMBODIMENTS

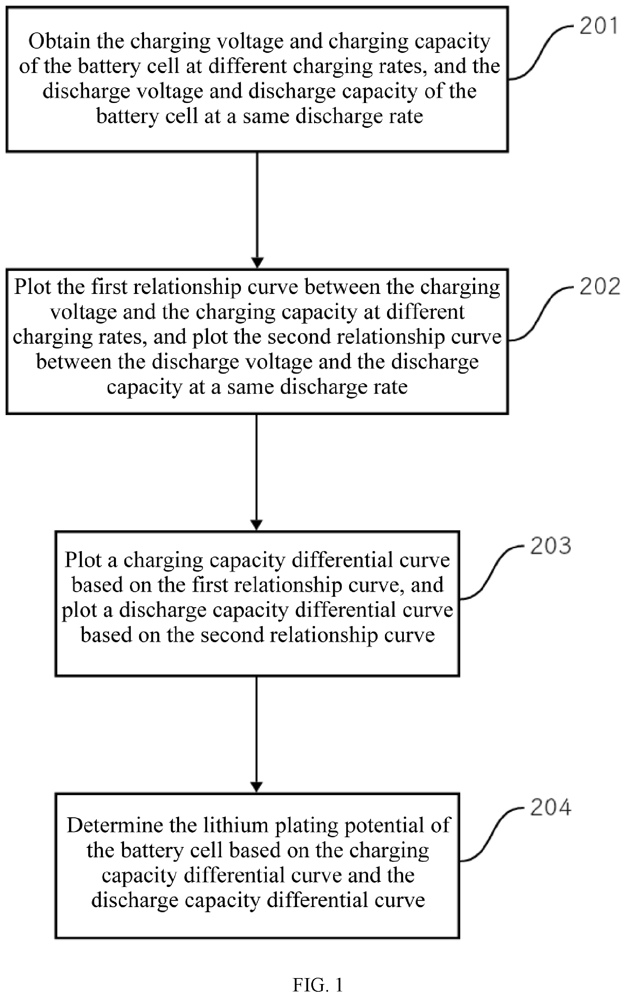

As shown in FIG. 1, FIG. 1 is a schematic flowchart of a method for determining a lithium plating potential of a battery cell provided by an embodiment of the present application, the method for determining a lithium plating potential of a battery cell comprising:
step 201: obtaining a charging voltage and a charging capacity of a battery cell at different charging rates, and a discharge voltage and a discharge capacity of the battery cell at a same discharge rate.

Data such as the charging voltage and the charging capacity of the battery cell at different charging rates, and the discharge voltage and the discharge capacity of the battery cell at a same discharge rate may be stored in advance and then obtained directly when needed.

In an embodiment, before obtaining the charging voltage and the charging capacity of the battery cell at different charging rates, the method further comprises: performing a charging test on the battery cell at different charging rates, and collecting the charging voltage and the charging capacity of the battery cell at different charging rates during the charging test; immediately performing a discharge test on the battery cell at the same discharge rate after each charging test is completed, and collecting the discharge voltage and the discharge capacity of the battery cell at the corresponding same discharge rate during the discharge test.

A plurality of groups of different charging rates are preset, for example: 0.1C, 0.33C, 0.5C, 1.0C, 1.5C, 2.0C, 3.0C. The battery cell is subjected to grouped constant-current charging tests at the above preset charging rates, and the termination condition of the charging test is the maximum charging cut-off voltage permitted for the battery cell, that is, during the charging test, the charging test stops when the voltage of the battery cell rises to the maximum charging cut-off voltage permitted for the battery cell. The voltage information and the capacity information of the battery cell during the charging test are collected.

A group of discharge rates is preset, for example: 0.2C. After the charging test of the battery cell is completed, a discharge test is performed on the battery cell that has completed the charging test at the above preset discharge rate. It should be noted that the battery cells at different charging rates are all discharged at the above preset discharge rate, that is, the discharge rate of all battery cells is the same. The termination condition of the discharge test is that the battery cell is discharged to the minimum discharge cut-off voltage permitted for the battery cell, that is, during the discharge test, the discharge test stops when the voltage of the battery cell drops to the minimum discharge cut-off voltage permitted for the battery cell. The voltage information and the capacity information of the battery cell during the discharge test are collected.

It should be noted that different charging rates may be set separately according to different situations, the charging rates needing to satisfy the condition of not exceeding the maximum rate permitted for continuous charging of the battery cell. The above examples are only intended to better illustrate this embodiment and should not be understood as limitations to the present solution.

In an embodiment, the discharge test is performed on the battery cell immediately after the above charging test of the battery cell is completed, that is, the time interval between the charging test of the battery cell and the discharge test of the battery cell is 0 seconds. This is because if the battery cell is allowed to rest after the charging test of the battery cell is completed, and the amount of lithium plating produced during charging is small, complete lithium re-intercalation may occur during the resting period. By setting the time interval between the charging test of the battery cell and the discharge test of the battery cell to 0 seconds, the problem of lithium re-intercalation caused by resting of the battery cell after the charging test of the battery cell is avoided, thereby preventing the misjudgement that lithium plating does not exist.

In an embodiment, the step of collecting the charging voltage and the charging capacity of the battery cell at different charging rates comprises: determining a collection time interval of the battery cell at different charging rates, and collecting the charging voltage and the charging capacity of the battery cell at different charging rates based on the collection time interval at different charging rates. Specifically, the collection time interval may decrease as the charging rate increases, that is, the higher the charging rate, the smaller the time interval for collecting data at the charging rate. It is only necessary to satisfy the condition that, when the battery cell is charged at a specific charging rate, data is collected at the specific collection time interval such that the density of the collected data meets the preset requirement. The collection time interval may also be a specific collection time interval, and during charging at different charging rates, data is collected at the specific collection time interval such that the density of the collected data meets the preset requirement. For example, the preset requirement is: when the capacity of the battery cell changes by 0.5 Ah, at least 200 voltage values are collected. Different data densities may be set according to specific situations. It should be noted that the above examples of the preset requirement are only intended to better illustrate this embodiment and should not be understood as limitations to the present solution. By defining the collection time interval, the problem of collecting too few voltage and capacity data from the start of charging until the voltage of the battery cell rises to the target cut-off voltage due to the collection time interval being too long is avoided.

In an embodiment, during the above charging test and during the above discharge test, the method further comprises: collecting a temperature of the casing of the battery cell, and controlling the temperature of the casing of the battery cell to remain within a preset range by means of a cooling device based on the collected temperature information of the casing of the battery cell. For example, the preset range is: the maximum temperature variation of the casing of the battery cell during the charging test and during the discharge test is 2 degrees Celsius. It should be noted that different preset ranges may be set according to different situations, and the above example is only intended to better illustrate this embodiment. Furthermore, no limitation is made herein on the manner of collecting the above data, the cooling device, or the cooling method. By controlling the temperature of the casing of the battery cell to remain within the preset range, the problem that the lithium plating potential is affected by high temperature under conditions of a high charging rate, which in turn leads to inaccurate determination of the lithium plating potential, is avoided.

step 202: plotting a first relationship curve of the charging voltage and the charging capacity at different charging rates, and plotting a second relationship curve of the discharge voltage and the discharge capacity at a same discharge rate.

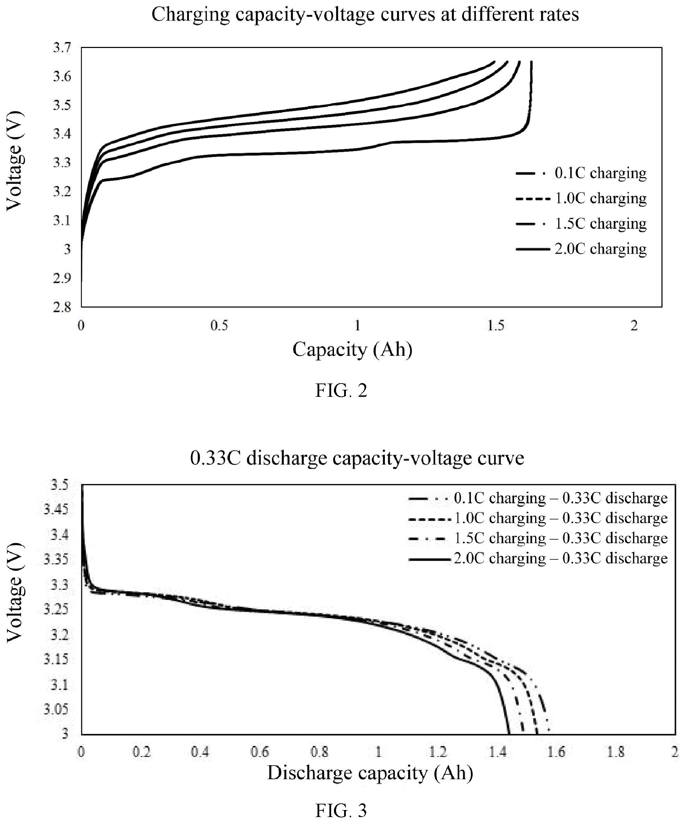

Specifically, based on the charging voltage and charging capacity information collected at different charging rates in step 201, a first relationship curve of the charging voltage and the charging capacity at different charging rates is plotted, as shown in FIG. 2, wherein FIG. 2 contains four different curves respectively representing the relationship between the voltage and the capacity at different charging rates during the charging process; and based on the discharge voltage and discharge capacity information collected at the same discharge rate, a second relationship curve of the discharge voltage and the discharge capacity at a same discharge rate is plotted, as shown in FIG. 3, wherein FIG. 3 contains four different curves respectively representing the relationship between the voltage and the capacity at different charging rates and the same discharge rate during the discharge process.

step 203: plotting a charging capacity differential curve based on the first relationship curve, and plotting a discharge capacity differential curve based on the second relationship curve.

A charging capacity differential curve is plotted based on the first relationship curve obtained in step 202, and a discharge capacity differential curve is plotted based on the second relationship curve obtained in step 202.

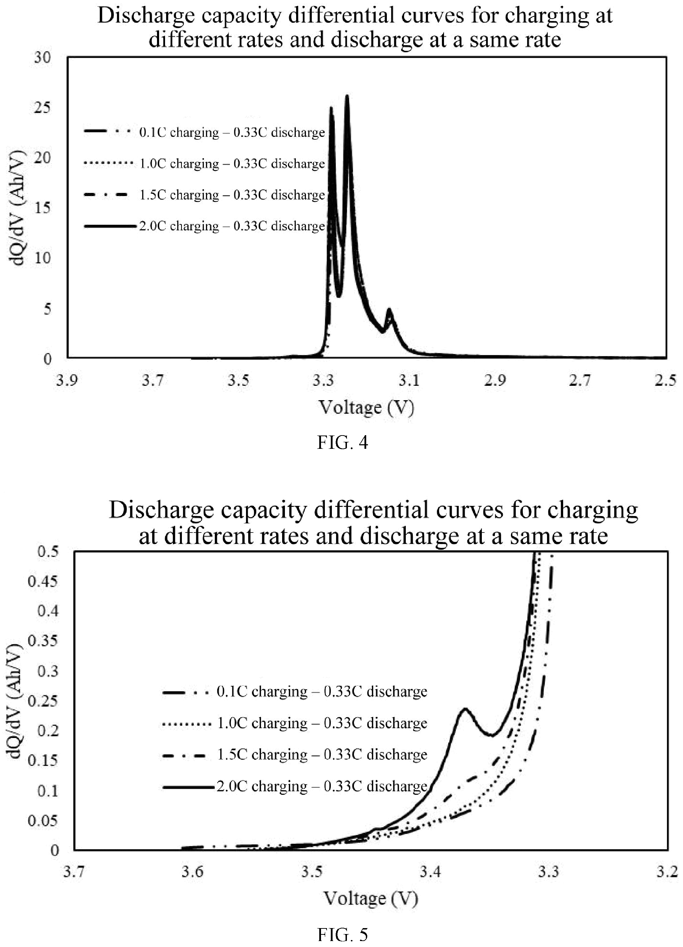

The step of plotting a charging capacity differential curve based on the first relationship curve comprises: presetting a first voltage interval, determining a first voltage value obtained by adding the preset first voltage interval to each voltage value in the first relationship curve and a first capacity value corresponding to the first voltage value, and determining a second voltage value obtained by subtracting the preset first voltage interval from each voltage value in the first relationship curve and a second capacity value corresponding to the second voltage value, and plotting the charging capacity differential curve based on the first voltage value, the first capacity value, the second voltage value, and the second capacity value. For example, the preset first voltage interval is a mV; each voltage value V in the first relationship curve is obtained; then a first voltage value V1 (i.e. V+a) obtained by adding the preset first voltage interval to the voltage value V is obtained, together with a first capacity value Q1 corresponding to the first voltage value V1; then a second voltage value V2 (i.e. V-a) obtained by subtracting the preset first voltage interval from the voltage value V is obtained, together with a second capacity value Q2 corresponding to the second voltage value V2. A dV value is obtained by V1-V2, and a dQ value is obtained by Q1-Q2. Each voltage value on the first relationship curve is processed through the above process, so that a plurality of dV, dQ values and their corresponding V values are obtained, thereby obtaining dQ/dV and the corresponding V, that is, the charging capacity differential curve is obtained, as shown in FIG. 4.

It should be noted that, in this process, the values of the above first voltage value V1 and the second voltage value V2 are both obtained by means of approximate searching. Specifically, when the value of the first voltage value V1 does not exist, the voltage value V3 closest to the first voltage value V1 is taken as the first voltage value V1. For example, when the preset first voltage interval is 5 mV, and the voltage value V is taken as 4 mV, then V1 would be -1 mV (i.e. 4-5 mV); obviously, the first voltage value V1 at this point does not exist, and therefore the voltage value V3 closest to the first voltage value V1 at this point is taken as the value of the first voltage value V1. At this point, the closest voltage value V3 is 0 mV, and therefore the value of the first voltage value V1 is replaced with 0 mV. Similarly, the second voltage value V2 may also be obtained by means of approximate searching with reference to the above description, which will not be repeated herein.

The step of plotting a discharge capacity differential curve based on the second relationship curve comprises: presetting a second voltage interval, determining a third voltage value V3 obtained by adding the preset second voltage interval to each voltage value in the second relationship curve and a third capacity value Q3 corresponding to the third voltage value V3, and determining a fourth voltage value V4 obtained by subtracting the preset second voltage interval from each voltage value in the second relationship curve and a fourth capacity value Q4 corresponding to the fourth voltage value V4, and plotting the discharge capacity differential curve based on the third voltage value V3, the third capacity value Q3, the fourth voltage value V4, and the fourth capacity value Q4. Specifically, this step is similar to the above step of plotting the charging capacity differential curve, and reference may be made to the above step of plotting the charging capacity differential curve, which will not be repeated herein. Similarly, it should be noted that, in this process, the values of V3 and V4 are also obtained by means of approximate searching, and reference may be made to the above description, which will not be repeated herein.

It should be noted that, in the embodiments of the present application, the above charging capacity differential curve and the discharge capacity differential curve are both first-order capacity differential curves. The above charging capacity differential curve and the discharge capacity differential curve may also be second-order or higher-order capacity differential curves, which is not limited herein.

step 204: determining the lithium plating potential of the battery cell based on the charging capacity differential curve and the discharge capacity differential curve.

The step of determining the lithium plating potential of the battery cell based on the charging capacity differential curve and the discharge capacity differential curve comprises: determining a candidate charging rate in the discharge capacity differential curve, determining a target potential and a target charging rate corresponding to the target potential based on the charging capacity differential curve corresponding to the candidate charging rate, and determining the target potential as the lithium plating potential at the target charging rate.

In an embodiment, the step of determining a candidate charging rate in the discharge capacity differential curve comprises: determining whether a characteristic peak of lithium dissolution exists in the discharge capacity differential curve and a charging rate corresponding to the discharge capacity differential curve; if the characteristic peak of lithium dissolution exists in the discharge capacity differential curve, determining the charging rate corresponding to the discharge capacity differential curve, and determining the charging rate corresponding to the discharge capacity differential curve as the candidate charging rate.

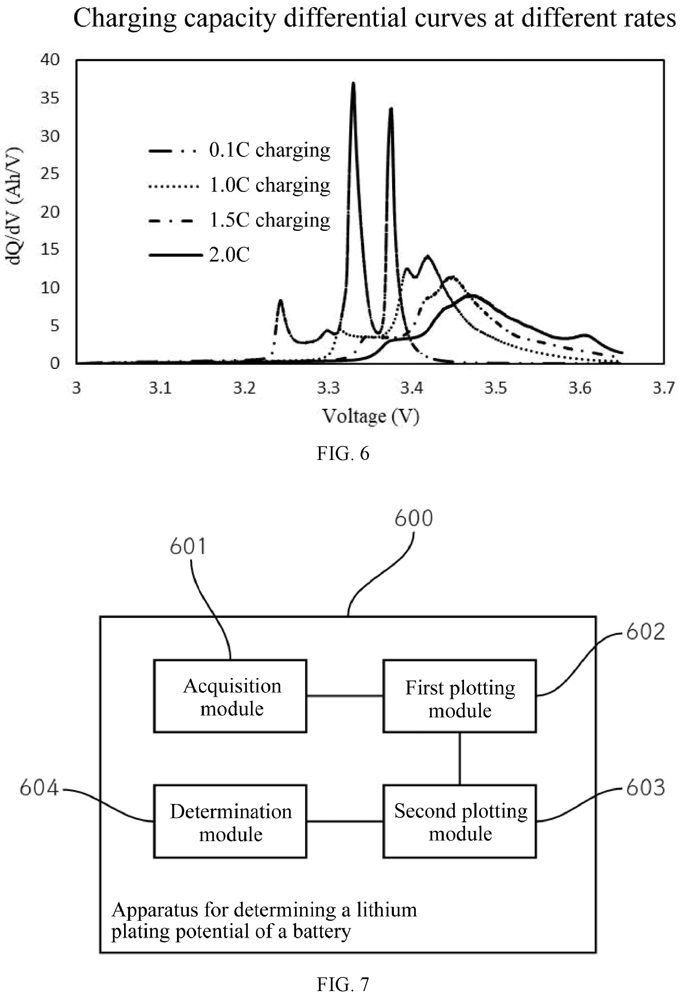

The step of determining a target potential and a target charging rate corresponding to the target potential based on the charging capacity differential curve corresponding to the candidate charging rate, and determining the target potential as the lithium plating potential at the target charging rate comprises: determining whether a characteristic peak of lithium dissolution exists in the discharge capacity differential curve and a charging rate corresponding to the discharge capacity differential curve; if the characteristic peak of lithium dissolution exists in the discharge capacity differential curve, determining the charging rate corresponding to the discharge capacity differential curve, finding a characteristic peak corresponding to lithium plating based on the charging capacity differential curve at the charging rate, wherein a potential at the onset point of the peak of the characteristic peak corresponds to the lithium plating potential at the target charging rate; if the characteristic peak of lithium dissolution does not exist in the discharge capacity differential curve, defining that lithium plating does not occur when charging to the cut-off voltage at the charging rate. The method for determining whether a characteristic peak corresponding to lithium plating exists in the charging capacity differential curve is as follows: the determination is made based on the number of characteristic peaks. Taking a lithium iron phosphate battery as an example, under normal circumstances, a battery cell of a lithium iron phosphate and graphite system has four characteristic peaks, each characteristic peak representing the formation process of a different lithium-carbon compound. If more than four peaks appear in the charging capacity differential curve, the last peak to appear is considered to be the characteristic peak corresponding to lithium plating, and the position of the onset point of the peak is determined as the lithium plating potential. For example, referring to FIG. 4, FIG. 5, and FIG. 6, wherein FIG. 5 is a partial-range data diagram of FIG. 4, as shown in FIG. 5, there exist a discharge capacity differential curve at a charging rate of 1.5C and a discharge rate of 0.33C, and a discharge capacity differential curve at a charging rate of 2.0C and a discharge rate of 0.33C, which exhibit characteristic peaks of lithium dissolution. Then, it is determined whether the charging capacity differential curve at a charging rate of 1.5C (as shown in FIG. 6) and the charging capacity differential curve at a charging rate of 2.0C exhibit more than four characteristic peaks. It can be seen that the charging capacity differential curve at a charging rate of 1.5C and the charging capacity differential curve at a charging rate of 2.0C both exhibit more than four characteristic peaks, indicating that lithium plating occurs during the charging process at charging rates of 1.5C and 2.0C. Based on the charging capacity differential curves, the corresponding lithium plating potentials are found to be 3.568 V and 3.609 V, respectively.

By combining the charging capacity differential curve and the discharge capacity differential curve to determine the lithium plating potential, the problem of possible misjudgement when using the charging capacity differential curve alone to determine the lithium plating potential is avoided, and at the same time, the problem that using the discharge capacity differential curve alone can only determine whether lithium plating exists but cannot determine the specific lithium plating potential is also solved, thereby making the method for determining a lithium plating potential of a battery cell more accurate.

In the solution disclosed by the embodiments of the present application, a charging voltage and a charging capacity of a battery cell at different charging rates, and a discharge voltage and a discharge capacity of the battery cell at a same discharge rate are obtained; a first relationship curve of the charging voltage and the charging capacity at different charging rates is plotted, and a second relationship curve of the discharge voltage and the discharge capacity at a same discharge rate is plotted; a charging capacity differential curve is plotted based on the first relationship curve, and a discharge capacity differential curve is plotted based on the second relationship curve; and the lithium plating potential of the battery cell is determined based on the charging capacity differential curve and the discharge capacity differential curve. The embodiments of the present application determine the lithium plating potential of the battery cell by combining the charging capacity differential curve and the discharge capacity differential curve, which solves the problem that using the discharge capacity differential curve alone leads to the inability to accurately and quantitatively calculate the lithium plating window, and also optimises the test method of the charging capacity differential curve, thereby improving the accuracy of the test.

The embodiments of the present application further provide an apparatus for determining a lithium plating potential of a battery cell. As shown in FIG. 7, the apparatus for determining a lithium plating potential of a battery cell comprises:
an acquisition module 601, configured to obtain a charging voltage and a charging capacity of a battery cell at different charging rates, and a discharge voltage and a discharge capacity of the battery cell at a same discharge rate;
a first plotting module 602, configured to plot a first relationship curve of the charging voltage and the charging capacity at different charging rates, and to plot a second relationship curve of the discharge voltage and the discharge capacity at a same discharge rate;
a second plotting module 603, configured to plot a charging capacity differential curve based on the first relationship curve, and to plot a discharge capacity differential curve based on the second relationship curve;
a determination module 604, configured to determine the lithium plating potential of the battery cell based on the charging capacity differential curve and the discharge capacity differential curve.

In an embodiment, the apparatus for determining a lithium plating potential of a battery cell further comprises a charging and discharging module. The charging and discharging module is configured to perform a charging test on a battery cell at different charging rates, and to collect the charging voltage and the charging capacity of the battery cell at different charging rates during the charging test; and to immediately perform a discharge test on the battery cell at the same discharge rate after each charging test is completed, and to collect the discharge voltage and the discharge capacity of the battery cell at the corresponding same discharge rate during the discharge test.

During specific implementation, each of the above modules and/or units may be implemented as independent entities, or may be combined in any combination and implemented as one or more entities. For the specific implementation of each of the above modules and/or units, reference may be made to the foregoing method embodiments. The advantageous effects that can be specifically achieved may also be found in the advantageous effects in the foregoing embodiments of the method for determining a lithium plating potential of a battery cell, which will not be repeated herein.

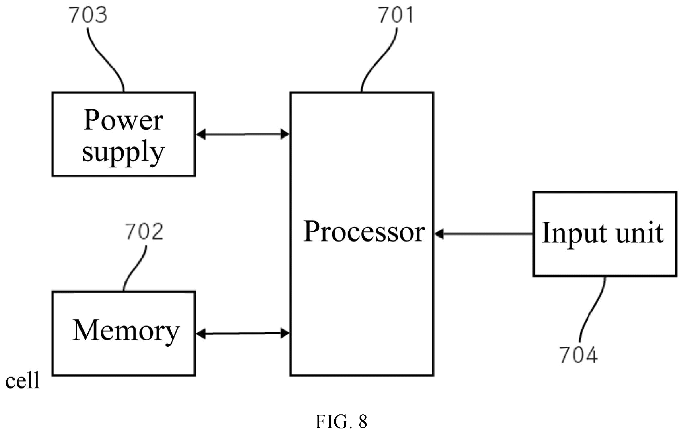

The embodiments of the present application further provide a computer device, the computer device comprising: one or more processors; a memory; and one or more instructions, wherein the one or more instructions are stored in the memory and configured to be executed by the processors to carry out the steps of the method for determining a lithium plating potential of a battery cell according to any one of claims 1 to 7. As shown in FIG. 8, FIG. 8 shows a schematic structural diagram of the computer device involved in the embodiments of the present application. Specifically:

The computer device may comprise a processor 701 having one or more processing cores, a memory 702 of one or more computer-readable storage media, a power supply 703, an input unit 704, and other components. A person skilled in the art would understand that the structure of the computer device shown in FIG. 8 does not constitute a limitation on the computer device, and may comprise more or fewer components than illustrated, or may combine certain components, or have different component arrangements. Among these:

The processor 701 is the control centre of the computer device, and connects the various parts of the entire computer device by means of various interfaces and lines. By running or executing software programs and/or modules stored in the memory 702, and calling data stored in the memory 702, the processor performs the various functions of the computer device and processes data, thereby performing overall monitoring of the computer device.

The memory 702 may be used for storing software programs and modules. The processor 701 executes various functional applications and data processing by running the software programs and modules stored in the memory 702.

The computer device further comprises a power supply 703 for supplying power to the various components. Preferably, the power supply 703 may be logically connected to the processor 701 through a power management system, so as to implement functions such as managing charging, discharging, and power consumption management through the power management system. The power supply 703 may also comprise any combination of components such as one or more direct-current or alternating-current power sources, a recharging system, a power failure detection circuit, a power converter or inverter, a power status indicator, and the like.

The computer device may further comprise an input unit 704. The input unit 704 may be used for receiving input digital or character information, and for generating keyboard, mouse, joystick, optical, or trackball signal inputs related to user settings and function control.

Although not shown, the computer device may further comprise a display unit, the display unit being used for displaying a human-machine interaction interface and the like, which will not be described in further detail herein. Specifically, in this embodiment, the processor 701 in the computer device loads executable files of the processes corresponding to one or more application programs into the memory 702 in accordance with the following instructions, and the processor 701 runs the application programs stored in the memory 702, thereby implementing the various functions, as follows:

obtaining a charging voltage and a charging capacity of a battery cell at different charging rates, and a discharge voltage and a discharge capacity of the battery cell at a same discharge rate; plotting a first relationship curve of the charging voltage and the charging capacity at different charging rates, and plotting a second relationship curve of the discharge voltage and the discharge capacity at a same discharge rate; plotting a charging capacity differential curve based on the first relationship curve, and plotting a discharge capacity differential curve based on the second relationship curve; determining the lithium plating potential of the battery cell based on the charging capacity differential curve and the discharge capacity differential curve.

A person of ordinary skill in the art would understand that all or part of the steps in the methods of the above embodiments may be completed by instructions, or by controlling related hardware through instructions, the instructions may be stored in a computer-readable storage medium, and may be loaded and executed by a processor.

To this end, the embodiments of the present application provide a computer-readable storage medium, which may be non-volatile or volatile. The storage medium may comprise: a read-only memory (ROM), a random-access memory (RAM), a magnetic disk or an optical disc, and the like. Computer programs are stored thereon, and the computer programs are loaded by a processor to execute the steps of any method for determining a lithium plating potential of a battery cell provided by the embodiments of the present application. For example, the computer programs may be loaded by a processor to execute the following steps:
obtaining a charging voltage and a charging capacity of a battery cell at different charging rates, and a discharge voltage and a discharge capacity of the battery cell at a same discharge rate;
plotting a first relationship curve of the charging voltage and the charging capacity at different charging rates, and plotting a second relationship curve of the discharge voltage and the discharge capacity at a same discharge rate;
plotting a charging capacity differential curve based on the first relationship curve, and plotting a discharge capacity differential curve based on the second relationship curve;
determining the lithium plating potential of the battery cell based on the charging capacity differential curve and the discharge capacity differential curve.

In the above embodiments, the descriptions of the various embodiments each have their own emphasis. For parts not described in detail in a particular embodiment, reference may be made to the detailed descriptions of the other embodiments above, which will not be repeated herein.

During specific implementation, each of the above units or structures may be implemented as independent entities, or may be combined in any combination and implemented as one or more entities. For the specific implementation of each of the above units or structures, reference may be made to the foregoing method embodiments, which will not be repeated herein.

The specific implementation of each of the above operations may be found in the foregoing embodiments, which will not be repeated herein.

## Claims

1. A method for determining a lithium plating potential of a battery cell, comprising:
obtaining a charging voltage and a charging capacity of the battery cell at different charging rates, and a discharge voltage and a discharge capacity of the battery cell at a same discharge rate;
plotting a first relationship curve of the charging voltage and the charging capacity at different charging rates, and plotting a second relationship curve of the discharge voltage and the discharge capacity at a same discharge rate;
plotting a charging capacity differential curve based on the first relationship curve, and plotting a discharge capacity differential curve based on the second relationship curve; and
determining the lithium plating potential of the battery cell based on the charging capacity differential curve and the discharge capacity differential curve.

2. The method for determining a lithium plating potential of a battery cell according to claim 1, wherein the determining of the lithium plating potential of the battery cell based on the charging capacity differential curve and the discharge capacity differential curve comprises:
determining a candidate charging rate in the discharge capacity differential curve;
determining a target potential and a target charging rate corresponding to the target potential based on the charging capacity differential curve corresponding to the candidate charging rate, and determining the target potential as the lithium plating potential at the target charging rate.

3. The method for determining a lithium plating potential of a battery cell according to claim 2,
wherein the determining of the candidate charging rate in the discharge capacity differential curve comprises:
determining whether a characteristic peak of lithium dissolution exists in the discharge capacity differential curve, and a charging rate corresponding to the discharge capacity differential curve;
if the characteristic peak of lithium dissolution exists in the discharge capacity differential curve, determining the charging rate corresponding to the discharge capacity differential curve, and determining the charging rate corresponding to the discharge capacity differential curve as the candidate charging rate;
and wherein the determining of the target potential and the target charging rate corresponding to the target potential based on the charging capacity differential curve corresponding to the candidate charging rate, and determining of the target potential as the lithium plating potential at the target charging rate comprises:
determining whether a characteristic peak of lithium dissolution exists in the discharge capacity differential curve, and a charging rate corresponding to the discharge capacity differential curve;
if the characteristic peak of lithium dissolution exists in the discharge capacity differential curve, determining the charging rate corresponding to the discharge capacity differential curve, finding a characteristic peak corresponding to lithium plating based on the charging capacity differential curve at the charging rate, wherein a potential at the onset point of the peak of the characteristic peak corresponds to the lithium plating potential at the target charging rate; if the characteristic peak of lithium dissolution does not exist in the discharge capacity differential curve, defining that lithium plating does not occur when charging to the cut-off voltage at the charging rate.

4. The method for determining a lithium plating potential of a battery cell according to any one of claims 1 to 3, wherein the plotting of the charging capacity differential curve based on the first relationship curve comprises:
presetting a first voltage interval, determining a first voltage value obtained by adding the preset first voltage interval to each voltage value in the first relationship curve and a first capacity value corresponding to the first voltage value, and determining a second voltage value obtained by subtracting the preset first voltage interval from each voltage value in the first relationship curve and a second capacity value corresponding to the second voltage value; and
plotting the charging capacity differential curve based on the first voltage value, the first capacity value, the second voltage value, and the second capacity value.

5. The method for determining a lithium plating potential of a battery cell according to any one of claims 1 to 3, wherein before the step of obtaining a charging voltage and a charging capacity of the battery cell at different charging rates, the method further comprises:
performing a charging test on the battery cell at different charging rates, and collecting the charging voltage and the charging capacity of the battery cell at different charging rates during the charging test; and
immediately performing a discharge test on the battery cell at the same discharge rate after each charging test is completed, and collecting the discharge voltage and the discharge capacity of the battery cell at the corresponding same discharge rate during the discharge test.

6. The method for determining a lithium plating potential of a battery cell according to claim 5, wherein the collecting of the charging voltage and the charging capacity of the battery cell at different charging rates comprises:
determining a collection time interval of the battery cell at different charging rates; and
collecting the charging voltage and the charging capacity of the battery cell at different charging rates based on the collection time interval at different charging rates.

7. The method for determining a lithium plating potential of a battery cell according to claim 5, the method for determining a lithium plating potential of a battery cell further comprising:
collecting a temperature of the casing of the battery cell during the charging test and during the discharge test; and
controlling the temperature of the casing of the battery cell to remain within a preset range by means of a cooling device.

8. The method for determining a lithium plating potential of a battery cell according to any one of claims 1 to 3, wherein the plotting of the discharge capacity differential curve based on the second relationship curve comprises:
presetting a second voltage interval, determining a third voltage value obtained by adding the preset second voltage interval to each voltage value in the second relationship curve and a third capacity value corresponding to the third voltage value, and determining a fourth voltage value obtained by subtracting the preset second voltage interval from each voltage value in the second relationship curve and a fourth capacity value corresponding to the fourth voltage value; and
plotting the discharge capacity differential curve based on the third voltage value, the third capacity value, the fourth voltage value, and the fourth capacity value.

9. An apparatus for determining a lithium plating potential of a battery cell, comprising:
an acquisition module (601), configured to obtain a charging voltage and a charging capacity of a battery cell at different charging rates, and a discharge voltage and a discharge capacity of the battery cell at a same discharge rate;
a first plotting module (602), configured to plot a first relationship curve of the charging voltage and the charging capacity at different charging rates, and to plot a second relationship curve of the discharge voltage and the discharge capacity at a same discharge rate;
a second plotting module (603), configured to plot a charging capacity differential curve based on the first relationship curve, and to plot a discharge capacity differential curve based on the second relationship curve; and
a determination module (604), configured to determine the lithium plating potential of the battery cell based on the charging capacity differential curve and the discharge capacity differential curve.

10. A computer-readable storage medium, wherein a plurality of instructions are stored in the computer-readable storage medium, the instructions being adapted to be loaded by a processor to execute the steps of the method for determining a lithium plating potential of a battery cell according to any one of claims 1 to 8.

11. An electronic device, the electronic device comprising: one or more processors; a memory; and one or more instructions, wherein the one or more instructions are stored in the memory and configured to be executed by the processors to carry out the steps of the method for determining a lithium plating potential of a battery cell according to any one of claims 1 to 8.
